Europäisches Patentamt

European Patent Office

Office européen des brevets

(19)

(11) **EP 0 474 185 B1**

(12) **FASCICULE DE BREVET EUROPEEN**

(45) Date de publication et mention
de la délivrance du brevet:
**20.11.1996 Bulletin 1996/47**

(51) Int Cl.⁶: **H03M 5/18**, H04L 25/49

(21) Numéro de dépôt: **91114836.9**

(22) Date de dépôt: **03.09.1991**

(54) **Décodeur pour un signal binaire codé selon un code bipolaire à inversion de marque**

Numerischer Datendekoder, nach einem bipolaren Markinvertierenden Kode kodiert

Digital data decoder, coded following a bipolar mark inversion code

(84) Etats contractants désignés:
**AT BE DE ES FR GB IT NL**

(30) Priorité: **07.09.1990 FR 9011118**

(43) Date de publication de la demande:
**11.03.1992 Bulletin 1992/11**

(73) Titulaire: **ALCATEL BUSINESS SYSTEMS**
**F-75008 Paris (FR)**

(72) Inventeurs:
• **Brunner, Frédéric**
**F-67400 Illkirch (FR)**
• **Medlicott, Mark**
**F-67400 Illkirch (FR)**

(74) Mandataire: **Weinmiller, Jürgen et al**
**Lennéstrasse 9**
**Postfach 24**
**82336 Feldafing (DE)**

(56) Documents cités:
**EP-A- 0 209 839**          EP-A- 0 291 246
**WO-A-85/05234**          WO-A-89/08364
**DE-A- 3 044 526**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

L'invention concerne un décodeur pour un signal binaire codé selon un code bipolaire à inversion de marque, et plus particulièrement un des codes pour lesquels le signal codé peut prendre trois valeurs, et où chaque bit est codé par une valeur qui dépend non seulement de ce bit mais aussi des bits qui l'ont précédé.

Un premier exemple de ce type de code est appelé communément "code à inversion de marque alternée" ou AMI (Alternate Mark Inversion). Selon le code AMI, un premier état logique, 0, est toujours représenté par une valeur nulle du signal codé, et un second état logique, 1, est représenté alternativement par deux valeurs algébriques opposées, +E et -E.

Un second exemple de code bipolaire à inversion de marque est le "code à réponse partielle d'ordre 4", ou PR4 (Partial Response 4). Selon le code PR4, la valeur codée de chaque bit est fonction de ce bit et du deuxième bit l'ayant précédé, par une fonction logique simple qui a pour effet qu'une suite d'états logiques 0 est codée par une suite de valeurs nulles, de même qu'une suite d'états logiques 1.

| Deuxième bit précédent | Premier bit précédent | Bit à coder | valeur du signal codé |
|:---:|:---:|:---:|:---:|
| 0 | Φ | 0 | 0 |
| 0 | Φ | 1 | +E |
| 1 | Φ | 0 | -E |
| 1 | Φ | 1 | 0 |

Φ désigne un état logique indifférent.

Ce type de code est utilisé dans le domaine des télécommunications car il ne nécessite pas la transmission d'une composante continue.

Pour détecter et décoder un tel signal à trois niveaux, il est connu de comparer le signal codé à deux valeurs de seuil, l'une positive et l'autre négative, pour décider si le signal reçu est de polarité positive, de polarité négative, ou de valeur nulle. Le signal parvenant à l'entrée d'un décodeur est généralement un signal qui est déformé et affaibli par un canal de transmission, telle qu'une paire torsadée. Les valeurs de seuil ont donc une valeur absolue qui est choisie inférieure à la valeur absolue nominale des niveaux du signal codé.

Un décodeur classique comporte : un comparateur pour comparer le signal codé à une valeur de seuil positive, un comparateur pour le comparer parallèlement à une valeur de seuil négative; et un circuit logique pour combiner les résultats de ces deux comparaisons. Un décodeur classique comporte donc une certaine redondance de matériel, puisque les deux comparateurs ne travaillent pas en parallèle mais travaillent alternativement. Cette redondance augmente le coût et la consommation du décodeur.

La demande de brevet européen EP 0291 246 décrit un décodeur pour signal AMI qui comprend :

- des moyens pour déterminer :

-- le signe qu'aura le signal codé, la prochaine fois où il aura une valeur non nulle, en fonction des états logiques décodés précédemment;
-- et en déduire une valeur ±S, positive ou négative selon les états logiques décodés précédemment, et fonction des échos attendus;

- des moyens pour additionner cette valeur ±S au signal à décoder;
- des moyens pour comparer la valeur résultant de l'addition, à une valeur de seuil, fixe et égale à zéro.
- des moyens pour inverser, ou ne pas inverser le résultat de la comparaison, en fonction des états logiques décodés précédemment, et fournir un signal binaire qui représente chaque état logique décodé.

Ce décodeur comporte donc un comparateur de moins que le décodeur classique, mais il comporte en plus des moyens pour additionner, et des moyens pour inverser.

Le but de l'invention est de réduire le coût et la consommation d'un tel décodeur. Cette réduction du coût et de la consommation est d'autant plus importante que le signal codé a un débit élevé.

L'objet de l'invention est un décodeur pour un signal binaire codé selon un code bipolaire à inversion de marque, chaque état logique étant représenté par une valeur du signal codé choisie parmi une valeur nulle et deux valeurs algébriques opposées, en fonction des niveaux logiques ayant précédé celui qui est codé, comportant :

- des moyens pour déterminer le signe qu'aura le signal codé la prochaine fois où il aura une valeur non nulle, en fonction des états logiques décodés précédemment;

- un comparateur unique ayant une première entrée pour recevoir une valeur du signal codé et une seconde entrée pour recevoir une seule valeur de seuil;
- des moyens pour inverser le résultat de la comparaison en fonction du signe qu'aura le signal codé la prochaine fois où il aura une valeur non nulle;

caractérisé en ce que les moyens pour inverser le résultat de la comparaison comportent un multiplexeur à deux entrées et une sortie, cette dernière étant couplée à l'une des deux entrées du comparateur, ce multiplexeur étant commandé en fonction du signe qu'aura le signal codé la prochaine fois où il aura une valeur non nulle.

Le décodeur ainsi caractérisé est plus simple qu'un décodeur de type classique puisqu'il comporte un comparateur unique pour comparer le signal à une seule valeur de seuil, au lieu de comporter deux comparateurs pour le comparer à deux valeurs de seuil parallèlement. D'autre part, il est plus simple que le décodeur connu par le document EP 0 291 246 puisque pour un même type de codage, il ne comporte ni inverseur commandé en fonction des états logiques décodés précédemment, ni additionneur analogique pour additionner au signal codé une valeur de seuil . Il comporte en plus seulement un multiplexeur.

L'invention sera mieux comprise et d'autres détails apparaîtront à l'aide de la description ci-dessous et des figures l'accompagnant :

- la figure 1 représente un chronogramme d'un exemple de signal codé selon le code AMI;
- la figure 2 représente le schéma synoptique d'un exemple de réalisation d'un décodeur AMI selon l'art antérieur;
- la figure 3 représente un premier exemple de réalisation de décodeur AMI, selon l'invention;
- la figure 4 représente un second exemple de réalisation de décodeur AMI, selon l'invention.
- la figure 5 représente un chronogramme d'un exemple de signal codé selon le code PR4;
- la figure 6 représente un exemple de réalisation de décodeur PR4, selon l'invention.

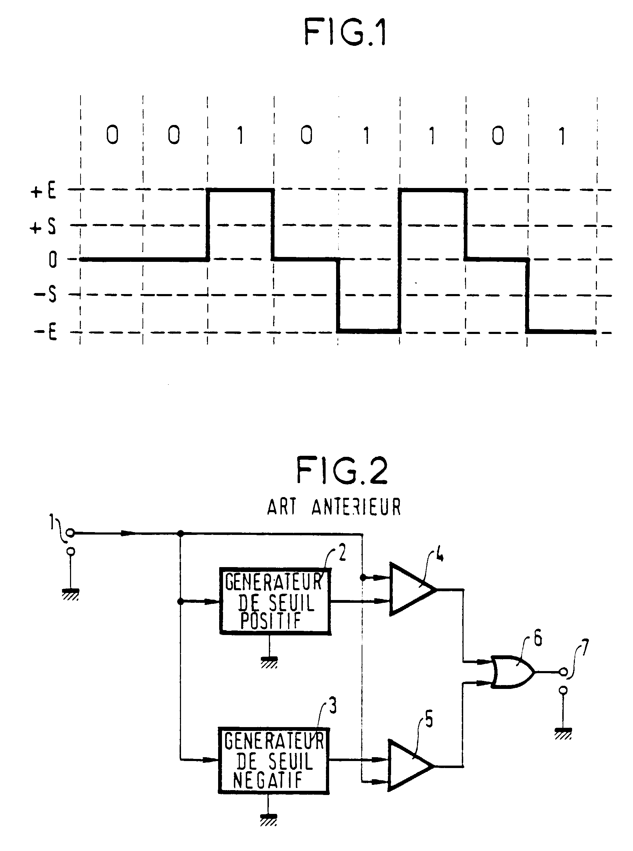

Le signal codé dont le chronogramme est représenté sur la figure 1 représente chaque bit ayant l'état logique 0 par une valeur 0; et représente : par une valeur +E le premier; le troisième,..., bit ayant l'état logique 1; et par une valeur -E, le deuxième, le quatrième,..., bit ayant l'état logique 1. Il y donc inversion alternée de la polarité du signal codé pour chaque nouveau bit ayant l'état logique 1.

Pour tenir compte des déformations et des affaiblissements du signal codé, un état logique 1 est considéré comme détecté lorsque le signal codé a une valeur positive supérieure à une valeur de seuil +S ou bien une valeur négative inférieure, en valeur algèbrique, à une valeur de seuil négative -S, la valeur absolue S de ces deux seuils étant choisie inférieure à la valeur absolue nominale des valeurs du signal codé représentant des niveaux logiques 1. La valeur S peut être asservie sur la valeur moyenne des crêtes positives ou des crêtes négatives du signal codé pour tenir compte des fluctuations de l'atténuation du canal de transmission.

La figure 2 représente le schéma synoptique d'un exemple de réalisation d'un décodeur AMI selon l'art antérieur, comportant :

- une entrée 1, recevant le signal codé;
- un générateur de seuil positif 2;
- un générateur de seuil négatif 3;
- deux comparateurs, 4 et 5;
- une porte logique OU 6;
- et une sortie 7 fournissant un signal binaire décodé.

Les générateurs 2 et 3 ont chacun une entrée reliée à l'entrée 1 du décodeur pour recevoir le signal codé et déterminer une valeur de seuil positif et une valeur de seuil négatif respectivement en fonction de la valeur moyenne des crêtes positives et de la valeur moyenne des crêtes négatives du signal codé. Une entrée inversante, du comparateur 4 est reliée à la sortie du générateur 2. Une entrée non inversante, notée +, du comparateur 5 est reliée à la sortie du générateur 3. Une entrée non inversante du comparateur 4, et une entrée inversante, notée -, du comparateur 5, sont reliées à l'entrée 1 du décodeur. Les sorties des comparateurs 4 et 5 sont reliées respectivement à deux entrées de la porte logique OU 6. La sortie de cette porte constitue la sortie 7 du décodeur.

Les comparateurs 4 et 5 ne basculent jamais en même temps car le signal codé ne peut être à la fois supérieur au seuil positif et inférieur au seuil négatif. Il est donc possible de multiplexer les valeurs de seuil et de n'utiliser qu'un seul comparateur. Le multiplexage nécessite de connaître la polarité du signal codé à comparer à un seuil. Dans le cas du code AMI, la polarité qu'aura le signal codé la prochaine où il représentera l'état logique 1, et toujours l'opposée de la polarité qu'avait le signal codé la dernière fois où il représentait l'état logique 1; par conséquent il est possible de prévoir la commande à appliquer à un multiplexage.

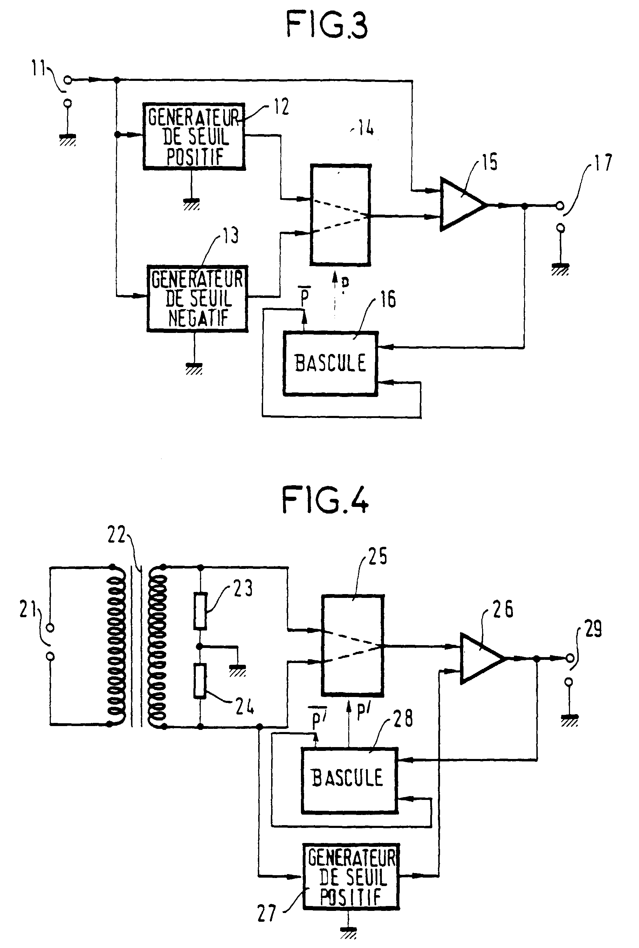

La figure 3 représente le schéma synoptique d'un premier exemple de réalisation de décodeur AMI selon l'invention, utilisant la prédiction de la polarité du signal codé, pour commander un multiplexage d'une valeur de seuil positif et d'une valeur de seuil négatif. Il comporte :

- une entrée 11 recevant le signal codé;
- un générateur de seuil positif, 12;
- un générateur de seuil négatif, 13;
- un multiplexeur 14, à deux entrées et une sortie;
- un comparateur unique, 15;
- une bascule de type D, 16;
- et une sortie 17 fournissant un signal binaire décodé.

Les générateurs de seuil 12 et 13 sont analogues à ceux du décodeur selon l'art antérieur, décrits précédemment. Ils possèdent une entrée reliée à l'entrée 11 du décodeur et des sorties reliées respectivement aux deux entrées du multiplexeur 14. La sortie du multiplexeur 14 est reliée à l'entrée inversante, du comparateur 15. L'entrée non inversante du comparateur 15 est reliée à l'entrée 11. Le multiplexeur 14 possède une entrée de commande recevant un signal logique P traduisant la polarité attendue du signal codé, pour le prochain état logique 1 qu'il représentera. Ce signal P est fourni par une sortie de la bascule 16. Celle-ci possède : une entrée de données reliée à une autre sortie de la bascule 16 fournissant un signal binaire $\overline{P}$ complémentaire de P; et une entrée d'horloge reliée à la sortie du comparateur 15. Cette dernière est reliée aussi à la sortie 17 du décodeur. Ainsi, chaque état logique 1 du signal décodé fourni par le comparateur 15 fait basculer la bascule 16 pour changer la valeur du signal binaire P.

Il y a un problème d'initialisation de la bascule 16 lors de la mise sous tension du décodeur. En effet, le décodeur ignore si le premier bit ayant l'état logique 1 sera codé par une polarité positive ou une polarité négative. Dans certaines applications, il peut être convenu que le signal codé est constitué de trames commençant systématiquement par un état logique prédéterminé, 1 par exemple, codé par une polarité prédéterminée, positive par exemple. Dans ce cas, il suffit de prévoir un circuit classique initialisant la bascule 16 de telle sorte qu'elle fournisse un signal P ayant une valeur correspondant à la polarité positive, chaque fois que le décodeur est mis sous tension.

Une autre option consiste à laisser la bascule 16 se mettre dans un état aléatoire lors de chaque mise sous tension du décodeur, et à admettre la perte éventuelle du premier bit ayant l'état logique 1, transmis par le signal codé. Le deuxième bit ayant l'état logique 1 est alors correctement décodé puisque, si la polarité indiquée par la bascule 16 est fausse une fois, elle ne change pas et elle devient vraie pour la fois suivante. Ensuite l'état de la bascule 16 change normalement lors du décodage de chaque état logique 1, et le décodage se poursuit donc correctement.

Il est à remarquer que les moyens logiques pour déduire un état logique en fonction du résultat de la comparaison réalisée par le comparateur 15, et en fonction des états logiques précédemment décodés, sont simplifiés puisque la porte OU 6 est remplacée par une liaison directe de la sortie du comparateur 15 à la sortie 17 du décodeur.

La figure 4 représente le schéma synoptique d'un second exemple de réalisation de décodeur AMI selon l'invention, utilisant une prédiction de la polarité du signal codé, pour multiplexer non pas deux valeurs de seuil, mais deux valeurs opposées du signal à décoder. Il comporte :

- une entrée 21 recevant le signal codé;
- un transformateur 22;
- deux résistances 23 et 24 ayant des valeurs égales;
- un multiplexeur 25, à deux entrées et une sortie;
- un comparateur unique 26;
- un générateur de seuil unique, 27;
- une bascule 28 de type D;
- et une sortie 29 fournissant un signal binaire décodé.

L'entrée 21 est reliée au primaire du transformateur 22. Le secondaire du tranformateur 22 comporte deux bornes qui sont reliées respectivement aux deux entrées du multiplexeur 25. Les résistances 23 et 24 constituent un pont dont le point milieu est relié au potentiel de référence du décodeur, et dont les deux extrémités sont reliées aux deux bornes du secondaire. Une entrée du générateur de seuil 27 est reliée à l'une des bornes du secondaire. La sortie du multiplexeur 25 est reliée à l'entrée non inversante, du comparateur 26. L'entrée inversante, du comparateur 26 est reliée à une sortie du générateur 27.

L'entrée de commande du multiplexeur 25 reçoit un signal binaire P' fourni par une sortie de la bascule 28 et indiquant la polarité prévue pour le signal codé lorsqu'il représentera le prochain état logique 1. Une entrée de données de la bascule 28 est reliée à une autre sortie de la bascule 28, qui fournit un signal logique $\overline{P}'$ complémentaire de P'. Une entrée d'horloge est reliée à la sortie du comparateur 26. Cette dernière est reliée aussi à la sortie 29 du décodeur. Le générateur 27 est analogue aux générateurs de seuil utilisés selon l'art antérieur, mais il fournit une seule valeur de seuil qui est, par exemple, positive. Au lieu de changer la valeur de seuil pour chaque état logique 1, cet exemple de réalisation change la polarité du signal codé appliqué à l'entrée non inversante du comparateur 26.

Cet exemple de réalisation est particulièrement simple puisqu'il n'y a qu'un seul générateur de seuil et qu'un seul comparateur. Le transformateur 22 est un dispositif relativement peu coûteux par rapport au prix d'un comparateur rapide, et d'un second générateur de seuil variable en fonction du signal codé. La portée de l'invention n'est pas limitée aux exemples de réalisation décrits ci-dessus. Par exemple, il est à la portée de l'homme de l'art de remplacer le transformateur 22 et les résistances 23 et 24 par un transformateur ayant un secondaire à point milieu, ce dernier étant relié au potentiel de référence du décodeur; ou bien de remplacer le transformateur par un amplificateur ayant un gain égal à -1.

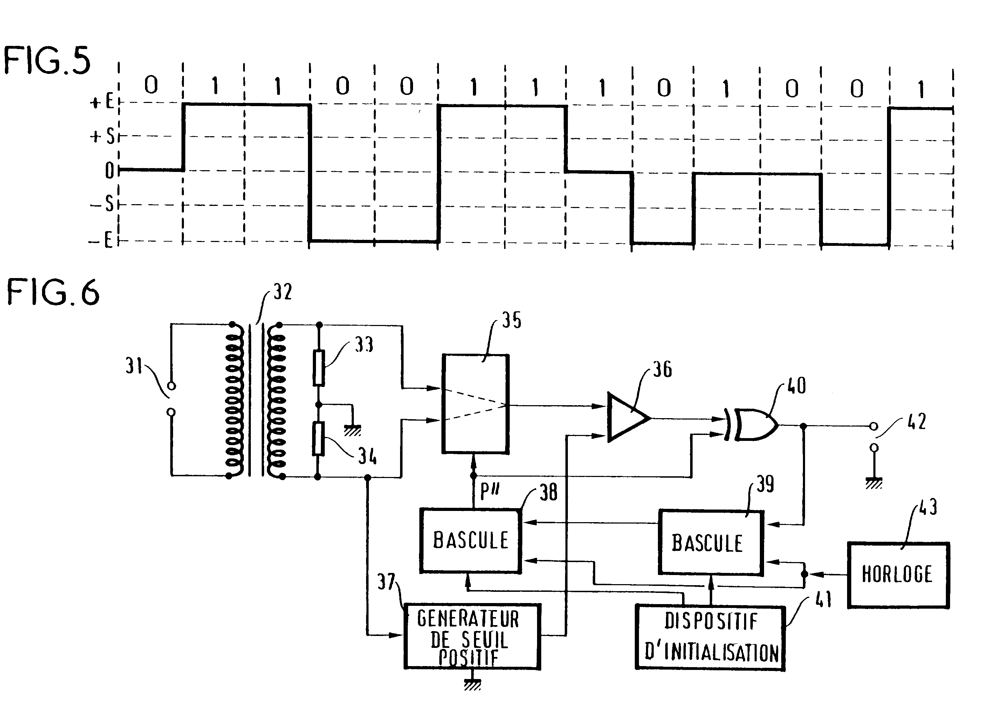

La figure 5 représente un chronogramme d'un exemple de signal binaire codé selon le code PR4. Il apparaît que prédire le signe qu'aura le signal codé pour représenter un état logique, est plus complexe que dans le cas du code AMI, car il ne s'agit pas d'une simple alternance. Le signal codé a une valeur non nulle et positive si, et seulement, si le bit à coder a un niveau logique 1 et si le deuxième bit précédent a un niveau logique 0. Le signal codé a une valeur non nulle et négative si, et seulement si, le bit à coder a le niveau logique 0 et si le deuxième bit précédent a le niveau logique 1. Pour prédire le signe du signal codé, il est donc nécessaire de disposer du niveau logique décodé pour le deuxième bit précédent le bit à coder. Si ce niveau logique est 0, le signal codé aura un valeur positive si elle n'est pas nulle. Si le niveau logique est 1, le signal codé aura une valeur négative si elle n'est pas nulle.

La figure 6 représente le schéma synoptique d'un exemple de réalisation de décodeur PR4, selon l'invention. Ce schéma est une adaptation du schéma représenté sur la figure 4: les moyens pour déterminer la polarité qu'aura le signal codé sont constitués de deux bascules 38 et 39, au lieu de la bascule unique 28; et les moyens logiques pour déduire le signal binaire décodé en fonction du résultat de la comparaison et en fonction des états logiques précédemment décodés, sont constitués d'une porte OU EXCLUSIF 40, au lieu d'une liaison directe.

Cet exemple de réalisation comporte :

- une entrée 31 recevant le signal codé;
- un transformateur 32;
- deux résistances 33 et 34 ayant des valeurs égales;
- un multiplexeur 35 à deux entrées et à une sortie;
- un comparateur unique 36;
- un générateur de seuil unique 37;
- deux bascules 38 et 39, de type D;
- une porte logique OU exclusive 40;
- un dispositif d'initialisation 41;
- une sortie 42 fournissant un signal binaire décodé et inversé.
- et une horloge 43 ayant une fréquence égale au rythme des bits.

Les éléments 31 à 37 sont respectivement analogues aux éléments 21 à 27 de l'exemple de réalisation représenté sur la figure 4. Le multiplexeur 35 est commandé par un signal binaire P" fourni par une sortie de la bascule 38 et qui représente le signe qu'aura le signal codé pour le prochain état logique représenté par une valeur non nulle. La bascule 38 possède : une entrée de données reliée à une sortie de la bascule 39, une entrée d'horloge reliée à la sortie de l'horloge 43, et une entrée d'initialisation reliée à une sortie du dispositif 41. La bascule 39 possède : une entrée de données reliée à la sortie de la porte 40, une entrée d'horloge reliée à la sortie de l'horloge 43, et une entrée d'initialisation reliée à une sortie du dispositif d'initialisation 41. Une première entrée de la porte 40 est reliée à la sortie du comparateur 36. Une seconde entrée de la porte 40 est reliée à la sortie de la bascule 38. La sortie de la porte 40 est reliée à la sortie 42 du décodeur.

Les bascules 38 et 39 étant reliées en série, elles procurent un retard correspondant à la durée de deux bits. La valeur du signal P" est donc égale à la valeur du deuxième bit, du signal décodé, précédant le bit qui va être décodé. Le générateur de seuil 37 fournissant une valeur de seuil positive, le multiplexeur 35 transmet le signal codé sans inversion de signe, lorsque le deuxième bit précédent a pour valeur 0; et au contraire, transmet le signal codé ayant un signe inversé, lorsque le deuxième bit précédent a pour valeur 1.

La porte 40 transmet la valeur binaire fournie par la sortie du comparateur 36, sans la modifier, dans les cas où la valeur du deuxième bit précédent est 0. La porte 40 transmet la valeur binaire fournie par le comparateur 36 en la complémentant dans le cas où la valeur du deuxième bit précédent est 1, afin d'obtenir la valeur binaire exacte correspondant à l'état logique à décoder, en fonction du résultat de la comparaison réalisé par le comparateur 36, et en fonction de l'état logique du deuxième bit précédent le bit en cours de décodage.

Il est nécessaire de connaître l'état logique du premier bit transmis pour pouvoir décoder correctement les bits de rang impair, et il est nécessaire de connaître l'état logique du deuxième bit transmis afin de décoder correctement les bits de rang pair. Le dispositif d'initialisation 41 charge les bascules 38 et 39 avec des valeurs binaires correspondant aux états logiques des deux premiers bits transmis, qui sont connus à l'avance. Par exemple, ces états logiques sont 1, et les bascules 38 et 39 sont chargés, lors de la mise sous tension du décodeur, de telle sorte que leurs sorties respectives fournissent une valeur 1.

L'application de l'invention au décodage d'un signal codé selon le code PR4, n'est pas limitée à cet exemple de réalisation. Il est à la portée de l'homme de l'art d'adapter le schéma représenté sur la figure 3, et décrit précédemment, pour réaliser un décodeur de signal PR4 comportant deux générateurs de seuil au lieu de comporter des moyens pot changer le signe du signal codé.

## Revendications

1. Décodeur pour un signal binaire codé selon un code bipolaire à inversion de marque, chaque état logique étant représenté par une valeur du signal codé, choisie parmi une valeur nulle et deux valeurs algébriques opposées (+E, -E), en fonction des niveaux logiques ayant précédé celui qui est codé, comportant :

   - des moyens (16; 28; 38, 39) pour déterminer le signe qu'aura le signal codé, la prochaine fois où il aura une valeur non nulle (+E, -E), en fonction des états logiques décodés précédemment;
   - un comparateur unique (15; 26; 36) ayant une première entrée pour recevoir une valeur du signal codé et une seconde entrée pour recevoir une seule valeur de seùil;
   - des moyens pour inverser le résultat de la comparaison en fonction du signe qu'aura le signal codé la prochaine fois où il aura une valeur non nulle;

   caractérisé en ce que les moyens pour inverser le résultat de la comparaison comportent un multiplexeur (14; 25; 35) à deux entrées et une sortie, cette dernière étant couplée à l'une des deux entrées du comparateur (15; 26; 36), ce multiplexeur étant commandé en fonction du signe qu'aura le signal codé la prochaine fois où il aura une valeur non nulle.

2. Décodeur selon la revendication 1, caractérisé en ce que la sortie du multiplexeur (14) est couplée à la première entrée du comparateur (15); la seconde entrée du comparateur (15) recevant directement le signal codé;
   et en ce que les moyens pour inverser comportent en outre des moyens (12, 13) pour fournir deux valeurs de seuil (+S; -S) ayant des signes opposés, respectivement aux deux entrées du multiplexeur (14).

3. Décodeur selon la revendication 1, caractérisé en ce que la sortie du multiplexeur (25) est couplée à la seconde entrée du comparateur (26); la première entrée du comparateur recevant une valeur de seuil fixée et en ce que les moyens pour inverser comportent en outre des moyens (22) pour fournir deux valeurs du signal codé, ayant des signes opposés, respectivement aux deux entrées du multiplexeur (25).

4. Décodeur selon la revendication 3, caractérisé en ce que les moyens pour fournir deux valeurs du signal codé, ayant des signes opposés, comportent un transformateur (22).

5. Décodeur selon la revendication 1, pour un signal codé selon un code bipolaire à marque alternée (AMI), caractérisé en ce que les moyens pour déterminer le signe qu'aura le signal codé comportent une bascule (16; 28) commandée par le signal binaire décodé.

6. Décodeur selon la revendication 1, pour un signal codé selon un code bipolaire à réponse partielle d'ordre 4 (PR4), caractérisé en ce que les moyens pour déterminer le signe qu'aura le signal codé comportent :

   - deux bascules (38, 39), en série, commandées par les états logiques décodés;
   - un dispositif (41) d'initialisation des bascules (38, 39);

   et en ce que le décodeur comporte en outre une porte OU EXCLUSIF (40) ayant une entrée reliée à une sortie du comparateur (36) et une entrée reliée à une sortie des moyens (38, 39) pour déterminer le signe.

## Patentansprüche

1. Dekodierer für ein Binärsignal, das gemäß einem bipolaren Kode mit Markenumkehr kodiert ist, wobei jeder logische Zustand durch einen Wert des kodierten Signals repräsentiert wird, der einen Wert O oder, je nach den früher kodierten logischen Pegeln, einen von zwei algebraisch gesehen entgegengesetzten Werten (+E, -E) annimmt,

- mit Mitteln (16, 28, 38, 39), um das Vorzeichen eines kodierten Signals zu bestimmen, wenn dieses einen Wert ungleich Null (+E, -E) hat, und zwar abhängig von den früher dekodierten logischen Zuständen,
- mit einem einzigen Komparator (15, 26, 36), der an einem ersten Eingang einen Wert des kodierten Signals empfängt und an einem zweiten Eingang einen einzigen Schwellwert,
- mit Mitteln, um das Ergebnis des Vergleichs abhängig vom Vorzeichen umzukehren, das das kodierte Signal beim nächsten Mal haben wird, wenn es einen Wert ungleich Null besitzt, dadurch gekennzeichnet, daß die Mittel zur Umkehr des Vergleichsergebnisses einen Multiplexer (14, 25, 35) mit zwei Eingängen und einem Ausgang aufweisen und daß der Multiplexer an einen der beiden Eingänge des Komparators (15, 26, 36) angeschlossen ist und abhängig vom Vorzeichen gesteuert wird, das das kodierte Signal beim nächsten Mal haben wird, wenn es einen Wert ungleich Null besitzt.

2. Dekodierer nach Anspruch 1, dadurch gekennzeichnet, daß der Ausgang des Multiplexers (14) an den ersten Eingang des Komparators (15) angeschlossen ist und der zweite Eingang des Komparators (15) unmittelbar das kodierte Signal empfängt, und daß die Mittel zur Umkehr der Vergleichsergebnisse außerdem Mittel (12, 13) aufweisen, um zwei Schwellwerte (+S, -S) mit entgegengesetzten Vorzeichen an die beiden Eingänge des Multiplexers (14) zu liefern.

3. Dekodierer nach Anspruch 1, dadurch gekennzeichnet, daß der Ausgang des Multiplexers (25) an den zweiten Eingang des Komparators (26) gekoppelt ist, wobei der erste Eingang des Komparators einen festgelegten Schwellwert empfängt, und daß die Mittel zur Umkehr der Vergleichsergebnisse weiter Mittel (22) enthalten, die zwei Werte des kodierten Signals mit entgegengesetzten Vorzeichen an je einen der Eingänge des Multiplexers (25) liefern.

4. Dekodierer nach Anspruch 3, dadurch gekennzeichnet, daß die Mittel, die zwei Werte des kodierten Signals mit entgegengesetzten Vorzeichen liefern, einen Transformator (22) enthalten.

5. Dekodierer nach Anspruch 1 für ein Signal, das gemäß einem bipolaren Kode mit wechselnder Marke (AMI) kodiert ist, dadurch gekennzeichnet, daß die Mittel zur Bestimmung des Vorzeichens, das das kodierte Signal haben wird, eine Kippstufe (16, 28) enthalten, die vom dekodierten Binärsignal gesteuert wird.

6. Dekodierer nach Anspruch 1 für ein Signal, das gemäß einem bipolaren Kode mit partieller Antwort der Ordnung 4 (PR4) kodiert ist, dadurch gekennzeichnet, daß die Mittel zur Bestimmung des Vorzeichens, das das kodierte Signal haben wird, zwei Kippstufen (38, 39) in Reihe, die von den dekodierten logischen Zuständen gesteuert werden, und eine Vorrichtung (41) zur Initialisierung der Kippstufen (38, 39) aufweisen und daß der Dekodierer weiter ein Exklusiv-ODER-Tor (40) enthält, das mit einem Eingang an einen Ausgang des Komparators und mit einem anderen Eingang an einen Ausgang der Mittel (38, 39) zur Bestimmung des Vorzeichens angeschlossen ist.

## Claims

1. A decoder for a binary signal encoded using a bipolar mark inversion code, each logic state being represented by a code signal value selected from a zero value and from a pair of algebraically opposite values (+E, -E), as a function of logic levels that have preceded the level being encoded, the decoder comprising:

   means (16; 28; 38, 39) for determining the sign that the code signal will have next time it takes a non-zero value (+E, -E), as a function of previously decoded logic states;
   a single comparator (15; 26; 35) having a first input for receiving a code signal value and a second input for receiving a single threshold value; and
   inverter means for inverting the result of the comparison as a function of the sign that the code signal will have next time it takes a non-zero value;
   the decoder being characterized in that the means for inverting the result of the comparison comprise a multiplexer (14; 25; 35) having two inputs and one output, the output being coupled to one of the two inputs of the comparator (15; 26; 36), said multiplexer being controlled as a function of the sign that the code signal will have next time it takes a non-zero value.

2. A decoder according to claim 1, characterized in that the output of the multiplexer (14) is coupled to the first input of the comparator (15); the second input of the comparator (15) receiving the code signal directly; and
in that the inverter means further include means (12, 13) for delivering two threshold values (+S, -S) of opposite signs, to the two inputs respectively of the multiplexer (14).

3. A decoder according to claim 1, characterized in that the output of the multiplexer (25) is coupled to the second input of the comparator (26); the first input of the comparator receiving a fixed threshold value; and in that the inverter means further include means (22) for delivering two code signal values of opposite sign, to the two inputs respectively of the multiplexer (25).

4. A decoder according to claim 3, characterized in that the means for providing two code signal values of opposite sign comprise a transformer (22).

5. A decoder according to claim 1, for a signal encoded using a bipolar alternate mark inversion code (AMI), characterized in that the means for determining the sign that the code signal will have comprise a bistable (16; 28) controlled by the decoded binary signal.

6. A decoder according to claim 1, for a signal encoded using a bipolar partial response code (PR4), characterized in that the means for determining the sign that the code signal will have comprise:

two bistables (38, 39) in series, controlled by the decoded logic states; and
a circuit (41) for initializing the bistables (38, 39); and
in that the decoder further includes an exclusive OR gate (40) having an input connected to an output of the comparator (36) and an input connected to an output of the means (38, 39) for determining the sign.

# FIG.1

# FIG.2
## ART ANTERIEUR

# FIG.3

GENERATEUR DE SEUIL POSITIF — 12

GENERATEUR DE SEUIL NEGATIF — 13

14

15

17

11

$\overline{P}$

D

BASCULE — 16

# FIG.4

22

25

26

29

21

23

24

$\overline{P'}$

$P'$

BASCULE — 28

GENERATEUR DE SEUIL POSITIF

27

# FIG.5

| 0 | 1 | 1 | 0 | 0 | 1 | 1 | 1 | 0 | 1 | 0 | 0 | 1 |

# FIG.6

EP 0 474 185 B1